# EUROPEAN PATENT APPLICATION

(11) **EP 4 333 062 A1**
(43) Date of publication of application: **06.03.2024**
(21) Application number: 22794752.0
(22) Date of filing: 21.04.2022
(51) Int. Cl.: H01L 27/108, H01L 27/06, H01L 21/8242

(54) **THREE-DIMENSIONAL MEMORY, CHIP PACKAGING STRUCTURE, AND ELECTRONIC DEVICE**

(30) Priority: 30.04.2021 CN 202110485941
(71) Applicant: Huawei Technologies Co., Ltd., Shenzhen, Guangdong 518129 (CN)
(72) Inventor: GU, Junxing, Shenzhen, Guangdong 518129 (CN)
(74) Representative: Huawei European IPR
(86) International application number: PCT/CN2022/088298
(87) International publication number: WO 2022/228281

(57) **Abstract**

This application provides a three-dimensional memory, a chip package structure, and an electronic device, and relates to the field of electronic device technologies. According to the three-dimensional memory in this application, a storage capability of a DRAM chip can be improved in limited layout space, a manufacturing process of a capacitor in the three-dimensional memory is less difficult, and a product qualification rate and reliability of the DRAM chip are high. An embodiment of this application provides a three-dimensional memory including a substrate and a storage array layer. The storage array layer includes at least one storage structure, and the storage structure includes N capacitors disposed side by side on the substrate. The capacitor includes a first electrode, a first dielectric layer, and a second electrode that are sequentially stacked on the substrate in a direction away from the substrate, N≥2, and N is an integer. The three-dimensional memory provided in this embodiment of this application is configured to store data.

## Description

This application claims priority to Chinese Patent Application No. 202110485941.9, filed with the China National Intellectual Property Administration on April 30, 2021 and entitled "THREE-DIMENSIONAL MEMORY, CHIP PACKAGE STRUCTURE, AND ELECTRONIC DEVICE", which is incorporated herein by reference in its entirety.

### TECHNICAL FIELD

This application relates to the field of electronic device technologies, and in particular, to a three-dimensional memory, a chip package structure, and an electronic device.

### BACKGROUND

To meet requirements of miniaturization and high integration of a semiconductor integrated circuit, a memory inside a terminal needs to feature both a small size and large storage capacity.

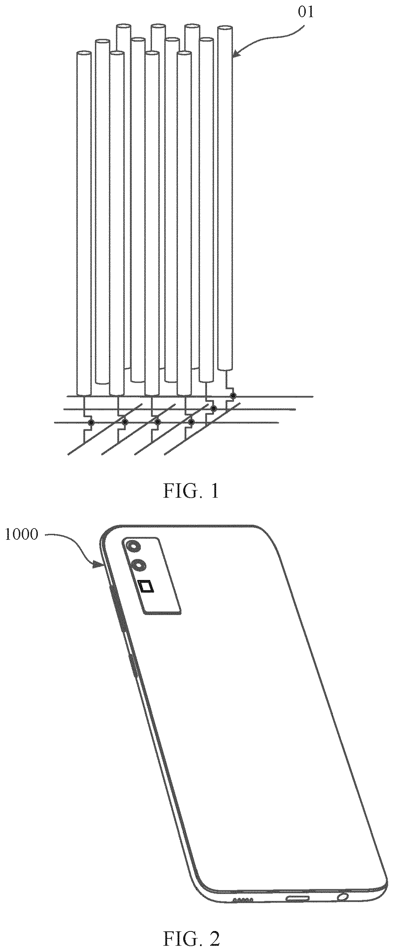

A dynamic random access memory (dynamic random access memory, DRAM) is used as an example, and a capacitor used by a storage unit in an existing DRAM may be a cylindrical capacitor 01 shown in FIG. 1. To reduce a size of the DRAM, a diameter of the cylindrical capacitor 01 is already close to a 2x nm process (a secondgeneration 10 nm process) level. In addition, a thickness of an intermediate dielectric layer of the cylindrical capacitor 01 is already close to a physical limit value of quantum tunneling. Therefore, a possibility of further miniaturization of the DRAM storage device is limited, and a memory with a large storage capacity is difficult to be disposed in limited layout space.

### SUMMARY

Embodiments of this application provide a three-dimensional memory, a chip package structure, and an electronic device, to improve a storage capability of a DRAM chip in limited layout space. In addition, a manufacturing process of a capacitor in the three-dimensional memory is less difficult, and a product qualification rate and reliability of the DRAM chip are high.

To achieve the foregoing objectives, the following technical solutions are used in embodiments of this application.

According to a first aspect, some embodiments of this application provide a three-dimensional memory including a substrate and a storage array layer. The storage array layer includes at least one storage structure, and the storage structure includes N capacitors disposed side by side on the substrate. The capacitor includes a first electrode, a first dielectric layer, and a second electrode that are sequentially stacked on the substrate in a direction away from the substrate, N≥2, and N is an integer.

The capacitor in the three-dimensional memory provided in this embodiment of this application includes the first electrode, the first dielectric layer, and the second electrode that are sequentially stacked on the substrate in a direction away from the substrate. In this case, the first electrode, the first dielectric layer, and the second electrode may be thin film layers that are sequentially stacked on the substrate by using thin film, exposure, development, and etching processes. This structure design can reduce a size of the capacitor in a direction perpendicular to the substrate. On this basis, the storage structure includes the N capacitors disposed side by side on the substrate. In this way, the N capacitors can be disposed in a direction parallel to a bearing surface of the substrate. In this case, compared with a cylindrical capacitor having a large size in a direction perpendicular to the substrate, the capacitor in this embodiment of this application has a small size in a direction perpendicular to the substrate. Therefore, in the three-dimensional memory in this embodiment of this application, a plurality of storage array layers can be superimposed on the substrate, that is, a plurality of capacitors are disposed. In this way, storage capacity of the three-dimensional memory is improved in limited layout space, and capacity expansion in a DRAM chip can be implemented in 1x nm (a firstgeneration 10 nm process). In addition, a manufacturing process of a capacitor having a thin-film layer structure is less difficult, and therefore, a manufacturing process of the plurality of storage array layers is also less difficult. Based on the foregoing description, in this embodiment of this application, the plurality of capacitors in the three-dimensional memory have good consistency and low defect states. Therefore, a defect rate of an electronic component in the three-dimensional memory is low, and reliability of the electronic component is high.

In a possible implementation of the first aspect, the first dielectric layer covers a surface that is of the first electrode and that is away from the substrate, and at least one side surface of the first electrode; and the second electrode covers a surface that is of the first dielectric layer and that is away from the substrate, and at least one side surface of the first dielectric layer. Second electrodes of two adjacent capacitors are disposed at an interval. The first dielectric layer covers both the surface that is of the first electrode and that is away from the substrate and one or more side surfaces of the first electrode; and the second electrode covers both the surface that is of the first dielectric layer and that is away from the substrate and one or more side surfaces of the first dielectric layer. Therefore, an area of overlap between the first electrode and the second electrode in the capacitor is large, so that a size of the capacitor is small when it is ensured that capacitance of the capacitor meets a storage requirement. In this way, a quantity of distributed capacitors on each storage array layer is increased, and capacity of the three-dimensional memory is further improved.

In a possible implementation of the first aspect, first dielectric layers of the N capacitors are of a connected integrated structure, and the first dielectric layers of the N capacitors can be manufactured by using one process (for example, a thin film deposition process) at a time. The process is simple, and manufacturing costs are reduced.

In a possible implementation of the first aspect, the three-dimensional memory includes M storage array layers that are stacked in a direction perpendicular to the substrate. M≥2, and M is an integer. The three-dimensional memory further includes a second dielectric layer, and the second dielectric layer is located between two adjacent storage array layers. For a three-dimensional memory stacked with more than two storage array layers, a second dielectric layer is manufactured to electrically isolate two adjacent storage array layers.

In a possible implementation of the first aspect, the N capacitors are disposed side by side in a first direction, and a first cross section of the first electrode is a trapezoid. The first cross section is parallel to the first direction and perpendicular to the substrate. Because a corner at corners of the first electrode is smooth, defect states at the corners of the first electrode can be reduced, and a qualification rate of the capacitor is high.

In a possible implementation of the first aspect, the storage structure further includes N gating transistors, a word line, and a bit line. A first electrode of one gating transistor is electrically connected to a first electrode of one capacitor; the word line is electrically connected to gates of the N gating transistors; and the bit line is electrically connected to second electrodes of the N gating transistors, to read and write data of the capacitor.

In a possible implementation of the first aspect, the storage structure further includes N gating transistors and a word line. A first electrode of one gating transistor is electrically connected to a first electrode of one capacitor; and the word line is electrically connected to gates of the N gating transistors. The three-dimensional memory further includes M storage array layers that are stacked in a direction perpendicular to the substrate. M≥2, and M is an integer. The three-dimensional memory further includes N bit lines. The bit lines pass through the M storage array layers and are electrically connected to second electrodes of M gating transistors at a same location in the M storage array layers. Vertical projections of the M gating transistors at the same location on the substrate overlap. In the solution, data reading and writing of the capacitor can also be implemented, and a length of the bit line is short.

In a possible implementation of the first aspect, the word line is disposed on a side that is of an active layer of the gating transistor and that is away from the substrate, and a part that is of the word line and that is lapped over the active layer serves as the gate of the gating transistor, so that the word line and the gate of the gating transistor are manufactured at the same time by using one patterning process. This simplifies process steps.

In a possible implementation of the first aspect, a second cross section of the first electrode is a rectangle. The second cross section is perpendicular to both the first direction and the substrate. A length direction of the rectangle is perpendicular to the first direction and parallel to the substrate. A side surface of the first electrode includes a first side surface and a second side surface that are both perpendicular to the first direction, and the first dielectric layer and the second electrode sequentially cover the first side surface and the second side surface. For the long strip-shaped first electrode, the first dielectric layer and the second electrode sequentially cover the first side surface and the second side surface that are of the first electrode and that are in the length direction, so that the area of overlap between the first electrode and the second electrode is large. Based on the foregoing description, in this solution, a size of the long strip-shaped first electrode can be reduced. In limited layout space, a quantity of capacitors that can be arranged at each storage array layer can be increased by using this solution. This improves capacity of the three-dimensional memory.

In a possible implementation of the first aspect, the side surface of the first electrode further includes a third side surface and a fourth side surface that are both parallel to the first direction, the third side surface is disposed close to the gating transistor and is electrically connected to the first electrode of the gating transistor, and the first dielectric layer and the second electrode further sequentially cover the fourth side surface. The area of overlap between the first electrode and the second electrode is further increased, and the size of the long strip-shaped first electrode is further reduced. In addition, the gating transistor is disposed close to the third side surface of the first electrode, and there is no need to reserve a location between two adjacent capacitors for the gating transistor. In this way, spacing between the two adjacent capacitors is small, and a quantity of capacitors that can be arranged at the single-layer storage array layer is further increased. This improves capacity of the three-dimensional memory.

In a possible implementation of the first aspect, the substrate is a silicon substrate. The first electrode, the second electrode, and the active layer of the gating transistor are integrated in the silicon substrate, and the first electrode that is of the capacitor and that is electrically connected to the first electrode of the gating transistor is on a same layer and of a same material as the gate of the gating transistor. In this solution, the first electrode of the capacitor and the gate of the gating transistor can be manufactured at the same time by using one patterning process. This simplifies a process flow and reduces manufacturing costs.

In a possible implementation of the first aspect, the storage array layer includes a plurality of storage structures arranged in an array, to further improve storage capacity of the three-dimensional memory.

According to a second aspect, some embodiments of this application provide a chip package structure, including a package substrate and the three-dimensional memory according to the foregoing embodiments. The three-dimensional memory is disposed on the package substrate. Because the chip package structure provided in this embodiment of this application includes the three-dimensional memory according to any one of the foregoing technical solutions, the chip package structure and the three-dimensional memory can resolve a same technical problem and achieve same technical effect. Details are not described herein again.

In a possible implementation of the second aspect, the chip package structure further includes a control chip. The control chip is disposed on the package substrate and is located on a same plane as the three-dimensional memory. Alternatively, the control chip and the three-dimensional memory are stacked on the package substrate, to meet size requirements of different terminal products.

According to a third aspect, some embodiments of this application provide an electronic device, including a mainboard and the chip package structure according to the foregoing embodiments. The chip package structure is disposed on the mainboard and is electrically connected to the mainboard. Because the electronic device provided in this embodiment of this application includes the chip package structure according to any one of the foregoing technical solutions, the electronic device and the chip package structure can resolve a same technical problem and achieve same technical effect.

### BRIEF DESCRIPTION OF DRAWINGS

FIG. 1 is a schematic diagram of a structure connection of a capacitor in a DRAM according to the conventional technology;
FIG. 2 is a schematic diagram of a structure of an electronic device according to some embodiments of this application;
FIG. 3 is an exploded view of the electronic device shown in FIG. 2;
FIG. 4 is a schematic diagram of a structure of a mainboard and a chip package structure in the electronic device shown in FIG. 3;
FIG. 5 is a schematic diagram of a structure of the chip package structure that is shown in FIG. 4 and that includes one chip;
FIG. 6 is a schematic diagram of a structure of the chip package structure that is shown in FIG. 4 and that includes two stacked chips;
FIG. 7 is a schematic diagram of a structure of the chip package structure that is shown in FIG. 4 and that includes two chips located on a same plane;
FIG. 8 is a schematic diagram of a structure of a three-dimensional memory in the chip package structure shown in FIG. 7;
FIG. 9 is a schematic diagram of a three-dimensional structure of a three-dimensional memory in Example 1;
FIG. 10 is a schematic diagram of a cross section obtained by cutting a capacitor shown in FIG. 9 along a first plane;
FIG. 11 is a schematic diagram of a cross section obtained by cutting a first type of capacitor shown in FIG. 9 along a second plane;
FIG. 12 is a schematic diagram of a cross section obtained by cutting a second type of capacitor shown in FIG. 9 along a second plane;
FIG. 13 is a schematic diagram of a cross section of A-A in FIG. 9;
FIG. 14 is a schematic diagram of a structure of the three-dimensional memory shown in FIG. 9;
FIG. 15 is a schematic diagram of a three-dimensional structure of a gating transistor in the three-dimensional memory shown in FIG. 9;
FIG. 16 is a schematic diagram of structures of a first type of gating transistor and a first type of capacitor in the three-dimensional memory shown in FIG. 9;
FIG. 17 is a schematic diagram of structures of a second type of gating transistor and a first type of capacitor in the three-dimensional memory shown in FIG. 9;
FIG. 18 is a schematic diagram of a structure of a second gating transistor located on a third side surface of a first electrode in the three-dimensional memory shown in FIG. 17;
FIG. 19 is a schematic diagram of a structure of a second gating transistor located on a fourth side surface of a first electrode in the three-dimensional memory shown in FIG. 17;
FIG. 20 is a schematic diagram of connections between a storage unit, a word line, and a bit line in the three-dimensional memory shown in FIG. 9;
FIG. 21 is a schematic diagram of connections between N storage units, a word line, and a bit line in the three-dimensional memory shown in FIG. 9;
FIG. 22 is a schematic diagram of a cross section of B-B in FIG. 9;
FIG. 23 is a schematic diagram of a three-dimensional structure of a three-dimensional memory in Example 2;
FIG. 24 is a schematic diagram of a structure of a chip stacked structure having a storage function in a related technology;
FIG. 25 is a schematic diagram of a cross section of C-C in FIG. 23;
FIG. 26 is a schematic diagram of a structure of both a word line and a bit line being located at a storage array layer in the three-dimensional memory shown in FIG. 23;
FIG. 27 is a schematic diagram of a structure of the three-dimensional memory shown in FIG. 23;
FIG. 28 is a schematic diagram of a cross section of D-D in FIG. 23;
FIG. 29 is a schematic diagram of connections between N×M storage units, M word lines, and N bit lines in the three-dimensional memory shown in FIG. 23;
FIG. 30 is a schematic diagram of a connection of a peripheral circuit included in the three-dimensional memory shown in FIG. 23;
FIG. 31 is a schematic diagram of a structure of a three-dimensional memory in Example 3;
FIG. 32 is a schematic diagram of a structure of a three-dimensional memory in Example 4;
FIG. 33 is a schematic diagram of a three-dimensional structure of the three-dimensional memory shown in FIG. 32;
FIG. 34 is a schematic diagram of a cross section of E-E in FIG. 33;
FIG. 35 is a schematic diagram of a cross section of F-F in FIG. 33; and
FIG. 36 is a schematic diagram of a structure of a chip stacked structure in an electronic device in Example 5.

### DESCRIPTION OF EMBODIMENTS

This application provides an electronic device. The electronic device may include a device that needs to store data, such as a mobile phone, a tablet personal computer (tablet personal computer), a laptop computer (laptop computer), a personal digital assistant (personal digital assistant, PDA), a camera, a personal computer, a notebook computer, a vehicle-mounted device, a wearable device, augmented reality (augmented reality, AR) glasses, an AR helmet, virtual reality (virtual reality, VR) glasses, or a VR helmet. A specific form of the electronic device is not specifically limited in this embodiment of this application. For ease of description, the following uses an example in which the electronic device is a mobile phone shown in FIG. 2 for description.

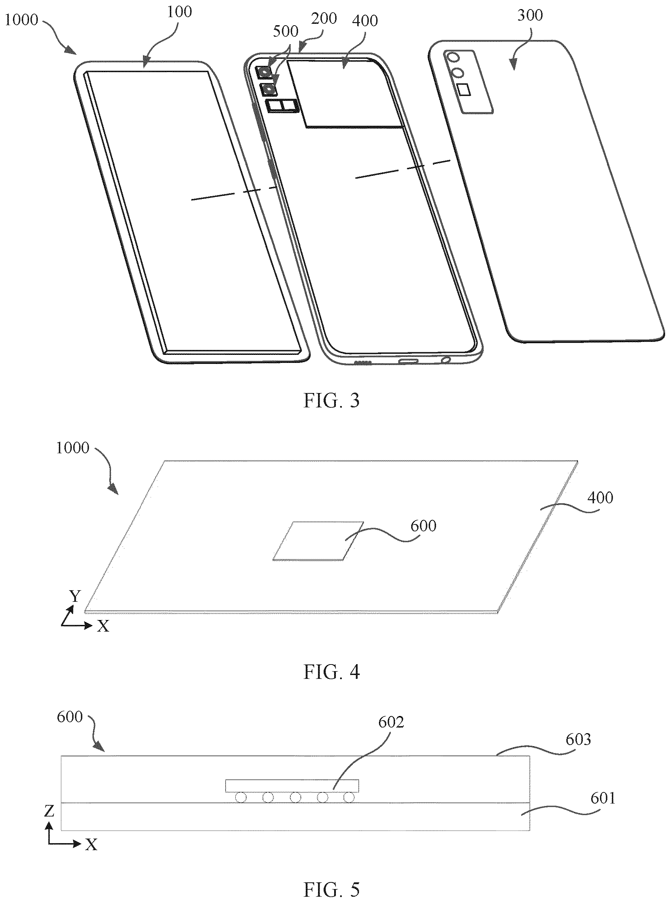

FIG. 2 is a three-dimensional diagram of an electronic device according to some embodiments of this application, and FIG. 3 is an exploded view of the electronic device shown in FIG. 2. It can be learned from the foregoing that, in this embodiment, the electronic device 1000 is a mobile phone. The electronic device 1000 may include a screen 100, a middle frame 200, a rear housing 300, and a mainboard 400 fastened on the middle frame 200 shown in FIG. 3.

It may be understood that FIG. 2 and FIG. 3 show only some components included in the electronic device 1000 as an example, and actual shapes, actual sizes, actual locations, and actual structures of these components are not limited by FIG. 2 and FIG. 3. In some other examples, the electronic device 1000 may not include the screen 100. Alternatively, the electronic device 1000 may further include a camera 500 shown in FIG. 3.

In some embodiments of this application, the electronic device 1000 may further include a chip package structure 600 shown in FIG. 4. The chip package structure 600 is disposed on the mainboard 400 and is electrically connected to the mainboard 400. For example, the chip package structure 600 may be electrically connected to the mainboard 400 by using a ball grid array (ball grid array, BGA) or a plurality of copper pillar bumps (copper pillar bump, CPB) arranged in an array. In this way, signal transmission between the chip package structure 600 and another chip or a chip stacked structure on the mainboard 400 can be implemented.

It should be noted that the mainboard 400 may be a printed circuit board (printed circuit board, PCB). A quantity of chip package structures 600 on the mainboard 400 is not limited in this application, and may be one, two, or more.

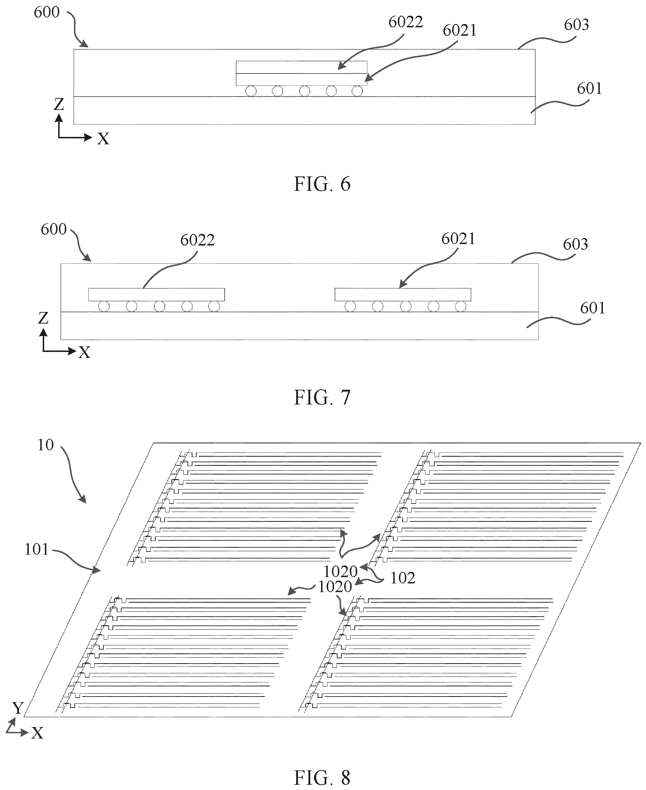

The following uses an example to describe a structure of the chip package structure 600. Refer to FIG. 5. The chip package structure 600 may include a package substrate (substrate, SUB) 601, a chip 602 disposed on the package substrate 601, and a molding material (molding) 603 for molding the chip 602. The chip 602 may be a die (die die), or may be a chip stacked structure (that is, a plurality of dies dies are stacked). A quantity of chips 602 packaged in the chip package structure 600 is not limited in this application. The quantity of chips 602 may be one shown in FIG. 5, or may be two shown in FIG. 6 and FIG. 7, or may be more than two.

For ease of description, the following uses an example in which a chip 6021 and a chip 6022 are packaged in the chip package structure 600 shown in FIG. 6 and FIG. 7 for description.

The chip 6021 in the chip package structure 600 shown in FIG. 6 may be a processing chip having a data processing function, for example, a chip that can process data, such as a central processing unit (central processing unit, CPU), a system on chip (system on chip, SOC), or a graphics processing unit (graphics processing unit, GPU). The another chip 6022 in the chip package structure 600 shown in FIG. 6 may be a chip having at least a storage function, and the chip may include a three-dimensional memory. Both the chip having a three-dimensional memory and the processing chip may be electrically connected to the package substrate 601. In this way, the chip having a three-dimensional memory and the processing chip may perform data transmission by using the package substrate 601.

It should be noted that the chip having at least a storage function indicates that the chip may have only a storage function. In this case, the chip is a storage chip. Alternatively, in addition to a storage function, the chip may have another function, for example, a data processing function. In this case, the chip is a multi-function integrated chip. The three-dimensional memory may be a DRAM storage device, for example, a double data rate synchronous dynamic random access memory (double data rate synchronous dynamic random access memory, DDR) or a low power double data rate synchronous dynamic random access memory (low power double data rate synchronous dynamic random access memory, LPDDR).

When installation locations of the chip 6021 and the chip 6022 are arranged on the package substrate 601, an arrangement manner in which the chip 6021 and the chip 6022 in the chip package structure 600 shown in FIG. 6 are stacked on the package substrate 601 may be used, or an arrangement manner in which the chip 6021 and the chip 6022 shown in FIG. 7 are located on a same plane may be used. Specifically, a proper orientation arrangement relationship of two or more chips may be selected based on an actual requirement of the electronic device.

It should be noted that the two chips shown in FIG. 6 and FIG. 7 are described by using an example in which the chip 6021 is a three-dimensional memory and the chip 6022 is a control chip. When three chips 602 are packaged in the chip package structure 600, one chip may be the processing chip having a data processing function, and the other two chips each may be the chip having at least a storage function. Alternatively, two of the three chips each are the chip having at least a storage function, and the remaining one of the three chips is the processing chip having a data processing function. An orientation arrangement manner of the plurality of chips on the package substrate 601 is the same as that described above, and details are not described herein again.

The following further describes a structure of the three-dimensional memory. A three-dimensional memory 10 shown in FIG. 3 includes a substrate 101 and a storage array layer 102, and the storage array layer 102 includes a storage structure 1020. The substrate 101 may also be referred to as a support base. The substrate 101 may be located below the storage array layer 102, and is configured to support the storage array layer 102. For example, the substrate 101 may be of a single-layer structure. In this case, the substrate 101 may be made of a semiconductor material, such as silicon, germanium, gallium arsenide, or indium phosphide. Alternatively, a material of the substrate 101 may be a non-conductive material, such as glass, plastic, or sapphire. For another example, the substrate 101 may be of a multi-layer structure. A layer that is farthest away from the storage array layer 102 may use the semiconductor material or the non-conductive material, and a patterning process may be performed on other film layers as required, to form another circuit structure.

It should be noted that the patterning process may include a photolithography process, or include a photolithography process and an etching step, and may further include other processes used to form a predetermined pattern, such as printing and inkjet. A corresponding patterning process may be selected based on the structure formed in this embodiment of this application. The photolithography process indicates a process that includes processes of film forming, exposing, developing, and the like and in which a photoresist, a mask reticle, an exposure machine, and the like are used to form a pattern.

For ease of description in the following, X, Y, and Z coordinate systems may be established in some accompanying drawings. As shown in FIG. 8, a plane on which the substrate 101 is located may be an XY plane. For example, the substrate 101 shown in FIG. 8 is a rectangle. An X axis may be a length direction of the substrate 101, a Y axis may be a width direction of the substrate 101, and a Z axis is a direction perpendicular to or approximately perpendicular to the substrate 101 within a manufacturing tolerance range. It may be understood that a size of a width of the substrate 101 is less than that of a length of the substrate 101.

The following describes a structure of the three-dimensional memory 10 in this embodiment of this application in detail with reference to different examples.

### Example 1

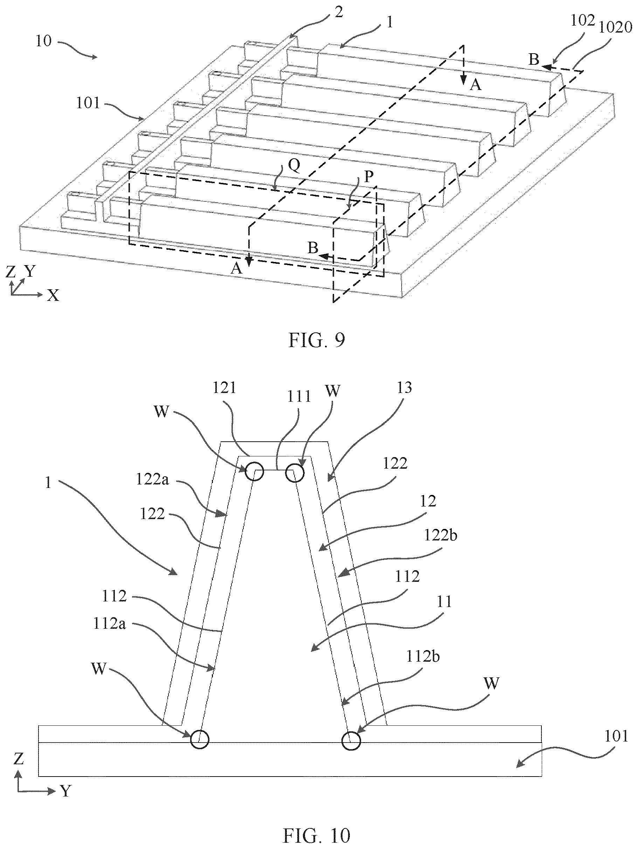

In this example, a three-dimensional memory 10 shown in FIG. 9 is used. The three-dimensional memory 10 includes a storage array layer 102, and the storage array layer 102 includes a storage structure 1020. The three-dimensional memory 10 in this example is a DRAM. The storage structure 1020 includes N capacitors 1 (N=6 is used as an example in FIG. 8) disposed on a substrate 101. The N capacitors 1 are disposed side by side in a first direction (the first direction is a Y-axis direction), N≥2, and N is an integer.

FIG. 10 is a cross-sectional view obtained by cutting the capacitor 1 shown in FIG. 9 along a first plane P parallel to the YZ plane. The capacitor 1 shown in FIG. 10 may include a first electrode 11, a first dielectric layer 12, and a second electrode 13. The first electrode 11, the first dielectric layer 12, and the second electrode 13 are sequentially stacked on the substrate 101 in a direction away from the substrate 101 (the direction away from the substrate 101 is a Z-axis direction).

In conclusion, the capacitor 1 in the three-dimensional memory 10 provided in this example includes the first electrode 11, the first dielectric layer 12, and the second electrode 13 that are sequentially stacked on the substrate 101 in the Z-axis direction. In this case, the first electrode 11, the first dielectric layer 12, and the second electrode 13 may be thin film layers that are sequentially stacked on the substrate 101 by using thin film, exposure, development, and etching processes. This structure design can reduce a size of the capacitor 1 in a direction perpendicular to the substrate 101. On this basis, the storage structure 1020 includes the N capacitors 1 disposed side by side on the substrate 101. In this way, the N capacitors 1 can be disposed in a direction parallel to a bearing surface (parallel to a XY plane) of the substrate 101. In this case, for a cylindrical capacitor 01 shown in FIG. 1, a size of the capacitor 1 in the Z direction is large. In this example, a size of the capacitor 1 in the Z direction is small. Therefore, in the three-dimensional memory 10 in this example, a plurality of storage array layers 102 can be superimposed on the substrate 101, that is, a plurality of capacitors 1 are disposed. In this way, storage capacity of the three-dimensional memory 10 is improved in limited layout space, and capacity expansion in a DRAM chip can be implemented in 1x nm (a firstgeneration 10 nm process). In addition, a manufacturing process of the capacitor 1 having a thin-film structure is less difficult, and therefore, a manufacturing process of the plurality of storage array layers 102 is also less difficult. The plurality of capacitors 1 in the three-dimensional memory 10 have good consistency and low defect states. Therefore, a defect rate of an electronic component in the three-dimensional memory 10 is low, and reliability of the electronic component is high.

In addition, the capacitor 1 in this example may be prepared by using an advanced process of 14 nm, 10 nm, 7 nm, or less (a minimum line width of a transistor in the chip). In this way, a three-dimensional memory having a small size and large capacity can be obtained.

It should be noted that, the first electrode 11 and the second electrode 13 in the capacitor 1 in this example may be made of a same material, or may be made of different materials. For example, each of the first electrode 11 and the second electrode 13 is made of any one of the following materials: cobalt (Co), titanium nitride (TiN), polycrystalline silicon, or the like. In this example, a material used for the first dielectric layer 12 of the capacitor 1 is a High-k (a high dielectric constant) dielectric material. For example, the material is any one of the following materials: aluminum oxide (Ai2O3), hafnium oxide (HfO2), or a multi-layer material including zirconium-aluminum. The High-k dielectric material is a material whose dielectric constant K is greater than 3.9.

When a shape of the capacitor 11 is designed, impact of a semiconductor manufacturing process factor is also considered. Still refer to FIG. 10. In this example, a first cross section of the first electrode 11 is a trapezoid. If the capacitor 1 is manufactured on the substrate 101 by using process steps such as etching and deposition, a corner at four corners W of the first electrode 11 is smooth. Defect states at the corners W of the first electrode 11 can be reduced, and a qualification rate of the capacitor 1 is high. It may be understood that the shape of the first electrode 11 may also be another shape that is convenient for manufacturing. For example, the first cross section of the first electrode 11 is of a semi-cylindrical shape.

Because an area in which the first dielectric layer 12 and the second electrode 13 in the capacitor 1 cover the first electrode 11 should be as large as possible, an area of overlap between the first electrode 11 and the second electrode 13 can be increased. In this way, when it is ensured that capacitance of the capacitor 1 meets a data storage requirement, a size of the capacitor 1 is small, and a quantity of capacitors 1 that can be distributed on the storage array layer 102 can be increased. Therefore, the capacitor 1 in this example uses a structure shown in FIG. 10, and the first dielectric layer 12 covers a surface (that is, an upper surface 111 of the first electrode 11) that is of the first electrode 11 and that is away from the substrate 101, and a side surface 112 of the first electrode 11. The second electrode 13 covers a surface (that is, an upper surface 121 of the first dielectric layer 12) that is of the first dielectric layer 12 and that is away from the substrate 101, and a side surface 122 of the first dielectric layer 12. In the capacitor 1 shown in FIG. 10, the area of overlap between the first electrode 11 and the second electrode 13 is large.

It should be noted that, in this example, an area in which the first dielectric layer 12 and the second electrode 13 cover the first electrode 11 is not limited. Alternatively, it may be designed that the first dielectric layer 12 in the capacitor 1 covers only the upper surface 111 of the first electrode 11, and the second electrode 13 covers only the upper surface 121 of the first dielectric layer 12.

It may be understood that, a larger area of the side surface 112 of the first electrode 11 covered by the first dielectric layer 12 and the second electrode 13 indicates a larger area of overlap between the first electrode 11 and the second electrode 13, a smaller size of the capacitor 1 that can be manufactured, and a larger quantity of capacitors 1 that can be distributed on the storage array layer 102.

For capacitors 1 of different shapes, quantities of side surfaces of the first electrode 11 in the capacitor 1 are different. The capacitor 1 shown in FIG. 9 is a strip-shaped convex structure disposed on the substrate 101, and may also be referred to as a horizontal fin structure. The horizontal refers to being disposed parallel to a plane on which the substrate 101 is located. The N capacitors 1 on the substrate 101 may be considered as a horizontal multifin structure disposed on the substrate 101, as shown in FIG. 9.

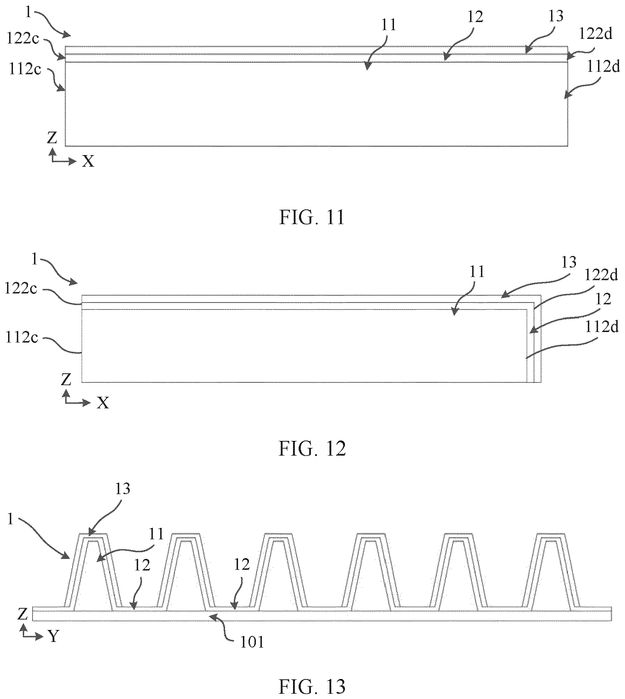

FIG. 11 is a cross-sectional view obtained by cutting a horizontal fin capacitor shown in FIG. 9 along a second cross section Q parallel to the X-Z plane. FIG. 12 is a cross-sectional view obtained by cutting another horizontal fin capacitor shown in FIG. 9 along a second cross section Q parallel to the X-Z plane. The second cross sections Q of the first electrode 11 of the capacitor 1 shown in FIG. 11 and FIG. 12 are rectangles.

With reference to the two horizontal fin capacitors shown in FIG. 10, FIG. 11, and FIG. 12, there are four side surfaces 112 of the first electrode 11, and the four side surfaces 112 of the first electrode 11 may be respectively a first side surface 112a and a second side surface 112b that extend in an X-axis direction, and a third side surface 112c and a fourth side surface 112d that extend in a Y-axis direction. Correspondingly, there are also four side surfaces 122 of the first dielectric layer 12, and the four side surfaces 122 of the first dielectric layer 12 are respectively a fifth side surface 122a and a sixth side surface 122b that extend in the X-axis direction, and a seventh side surface 122c and an eighth side surface 122d that extend in the Y-axis direction.

In the horizontal fin capacitors shown in FIG. 10 and FIG. 11, the first dielectric layer 12 covers the upper surface 111 of the first electrode 11, the first side surface 112a of the first electrode 11, and the second side surface 112b of the first electrode 11. The second electrode 13 covers the upper surface 121 of the first dielectric layer 12, the fifth side surface 122a of the first dielectric layer 12, and the sixth side surface 122b of the first dielectric layer 12. Because the first dielectric layer 12 and the second electrode 13 can cover the first side surface 112a and the second side surface 112b that are of the horizontal fin capacitor and that extend in a length direction, the area of overlap between the first electrode 11 and the second electrode 13 is large. Both the third side surface 112c and the fourth side surface 112d of the first electrode 11 are in an exposed state, so that the third side surface 112c of the first electrode 11 can be electrically connected to another component in the storage structure 1020, or the fourth side surface 112d of the first electrode 11 can be electrically connected to another component in the storage structure 1020.

In the horizontal fin capacitors shown in FIG. 10 and FIG. 12, the first dielectric layer 12 covers the upper surface 111 of the first electrode 11, the first side surface 112a of the first electrode 11, the second side surface 112b of the first electrode 11, and the fourth side surface 112d of the first electrode 11, and the second electrode 13 covers the fifth side surface 122a of the first dielectric layer 12, the sixth side surface 122b of the first dielectric layer 12, and the eighth side surface 122d of the first dielectric layer 12. Because the first dielectric layer 12 and the second electrode 13 can sequentially cover the first side surface 112a and the second side surface 112b that are of the long strip-shaped capacitor 1 and that extend in the length direction and the fourth side surface 112d that extends in the width direction, and the first dielectric layer 12 and the second electrode 13 can cover a large quantity of side surfaces and a large area of the long strip-shaped capacitor 1, the area of overlap between the first electrode 11 and the second electrode 13 is large. In addition, the third side surface 112c of the first electrode 11 is in an exposed state, so that the third side surface 112c of the first electrode 11 can be electrically connected to another component in the storage structure 1020.

FIG. 13 is a cross-sectional view of A-A in FIG. 9. For ease of manufacturing, the first dielectric layers 12 of the N capacitors 1 in the storage structure 1020 in this example are of a connected integrated structure shown in FIG. 13. The first dielectric layer 12 of the N capacitors 1 can be manufactured by using one process (for example, a thin film deposition process). The process is simple, and manufacturing costs are reduced.

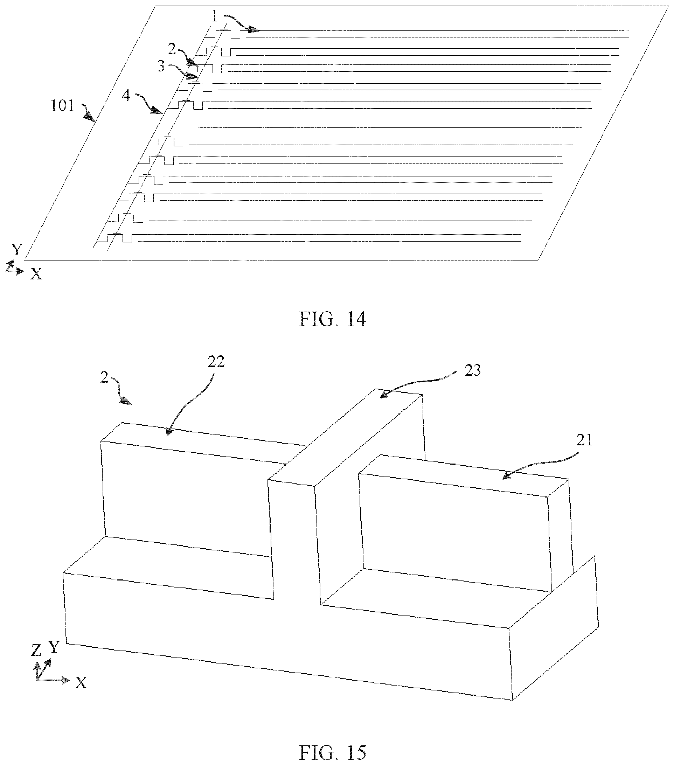

Based on this, to write data into the capacitor 1 or read data from the capacitor 1, the storage structure 1020 may further include a gating transistor 2 shown in FIG. 14, and the gating transistor 2 is electrically connected to the capacitor 1. When the gating transistor 2 is conducted, data is written into the capacitor 1 or read from the capacitor 1. When the gating transistor 2 is cut off, data reading from the capacitor 1 stops.

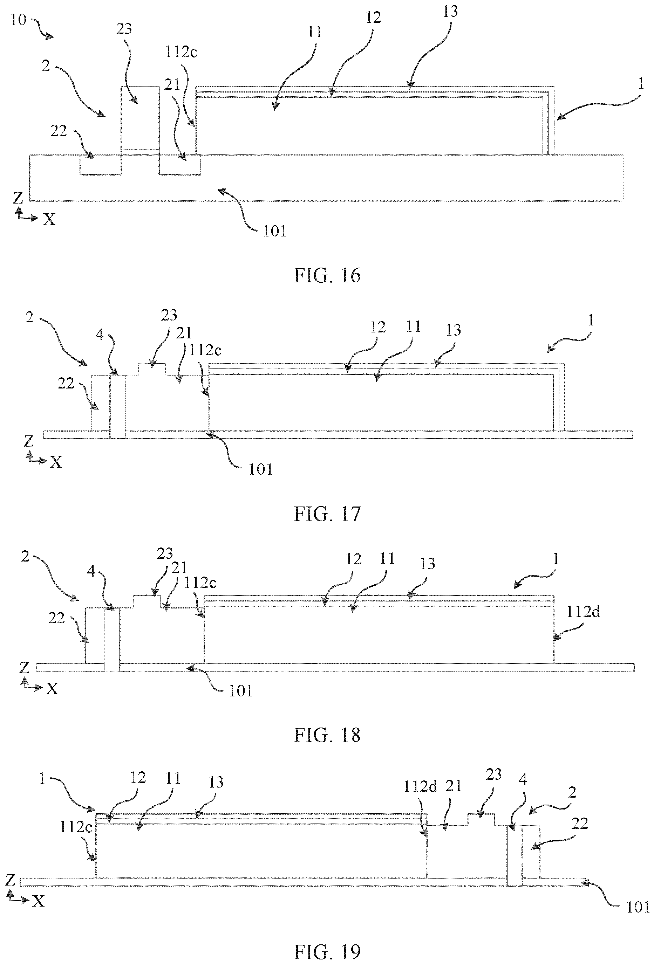

It should be noted that the gating transistor 2 in this example may be a metal-oxide-semiconductor field-effect transistor (metal-oxide-semiconductor field-effect transistor, MOSFET, where MOS transistor is short for MOSFET). The MOS transistor may include a first electrode 21, a second electrode 22, and a gate 23 shown in FIG. 15. The first electrode 21 of the gating transistor 2 is electrically connected to the first electrode 11 of the capacitor 1, as shown in FIG. 16. When a gating signal provided to the gate 23 of the MOS transistor is a valid signal, the MOS transistor is in a conduction state. In this case, the first electrode 21 and the second electrode 22 of the MOS transistor are electrically connected. When a gating signal provided to the gate 23 of the MOS transistor is a non-valid signal, the MOS transistor is in a cut-off state. In this case, the first electrode 21 and the second electrode 22 of the MOS transistor are disconnected. The gating transistor 2 shown in FIG. 15 is a fin field-effect transistor (fin field-effect transistor, FinFET).

A type of the MOS transistor is not limited in this example. The MOS transistor may be an N-type transistor. In this case, the gating signal is a valid signal, and may be a high level, and the non-valid signal may be a low level. On the contrary , the MOS transistor may be a P-type transistor. In this case, the gating signal is a valid signal and may be a low level, and the non-valid signal may be a high level. In addition, the first electrode 21 of the gating transistor 2 may be a source (source, S), and in this case, the second electrode 22 of the gating transistor 2 may be a drain (drain, D). Alternatively, the first electrode 21 of the gating transistor 2 may be a drain, and in this case, the second electrode 22 of the gating transistor 2 may be a source.

The whole or part of the gating transistor 2 in the three-dimensional memory 10 in this example is formed on the substrate 101 based on a material of the substrate 101, as shown in FIG. 16. Alternatively, the whole of the gating transistor 2 is directly formed on the substrate 101. For example, the substrate 101 is a silicon substrate, the source, the drain, and an active layer of the gating transistor 2 are integrated in the substrate 101, and the gate 23 of the gating transistor 2 is formed on the substrate 101, as shown in FIG. 16. The gating transistor 2 can be formed through a plurality of processes, including but not limited to: photolithography, dry/wet etching, thin film deposition, thermal growth, implantation, chemical mechanical polishing, and any other suitable process. For example, a doping region is formed in the silicon substrate by ion implantation and/or thermal diffusion, and is used as, for example, a source region and/or a drain region of the gating transistor 2.

In addition, the gate 23 of the gating transistor 2 shown in FIG. 16 and the first electrode 11 of the capacitor 1 are disposed at the same layer, and the first electrode 11 of the capacitor 1 may be on the same layer and of the same material as the gate 23 of the gating transistor 2. For example, the material is any one of the following: cobalt (Co), titanium nitride (TiN), or polycrystalline silicon. In this way, the gate 23 of the gating transistor 2 and the first electrode 11 of the capacitor 1 can be manufactured at the same time by using one patterning process. Therefore, a quantity of process flows is reduced, and manufacturing costs are reduced. Certainly, a material of the gate 23 of the gating transistor 2 may alternatively be different from that of the first electrode 11 of the capacitor 1. This is not limited herein, and may be specifically selected based on an actual requirement.

It should be noted that, "the same layer" refers to a layer structure formed by using a same film forming process to form a film layer for forming a specific pattern, and then by using a same mask template through one patterning process. According to different specific patterns, a same patterning process may include a plurality of exposure, development, or etching processes. Specific patterns in the formed layer structure may be continuous or discontinuous, and these particular patterns may be at different heights or have different thicknesses. In this example, one patterning process is described by using an example in which different exposure regions are formed by using one mask exposure process, and then removal processes such as etching and ashing are performed on the different exposure regions for a plurality of times to finally obtain an expected pattern.

When the substrate 101 is made of a non-metal material, the whole gating transistor 2 may be formed on the substrate 101, and the whole capacitor 1 and the gating transistor 2 may be disposed at a same layer, as shown in FIG. 17.

The gating transistor 2 may be disposed at different installation locations on the substrate based on the capacitor 1 of different shapes.

In the 4 side surfaces of the first electrode 11 in the capacitor 1 shown in FIG. 16 and FIG. 17, only the third side surface 112c is in an exposed state. Therefore, the first electrode 21 of the gating transistor 2 may be disposed close to the third side surface 112c of the first electrode 11. Because the gating transistor 2 is disposed on a side on which the width of the first electrode 11 of the horizontal fin capacitor is located, there is no need to reserve a location between two adjacent capacitors 1 for the gating transistor 2. In this way, spacing between the two adjacent capacitors 1 is small. In addition, a quantity of capacitors 1 that can be arranged at the storage array layer 102 is further increased. This improves storage capacity of the three-dimensional memory 10.

In the horizontal fin capacitor shown in FIG. 18 and FIG. 19, a solution that both the third side surface 112c and the fourth side surface 112d in the four side surfaces of the first electrode 11 are in an exposed state is used. The first electrode 21 of the gating transistor 2 shown in FIG. 18 is disposed close to the third side surface 112c of the first electrode 11 of the horizontal fin capacitor. The first electrode 21 of the gating transistor 2 shown in FIG. 19 is disposed close to the fourth side surface 112d of the first electrode 11 of the horizontal fin capacitor. Similarly, in the solutions shown in FIG. 18 and FIG. 19, the gating transistor 2 is also disposed on a side on which the width of the first electrode 11 of the horizontal fin capacitor is located. Therefore, a quantity of capacitors 1 that can be arranged at the storage array layer 102 can also be increased. This improves storage capacity of the three-dimensional memory 10.

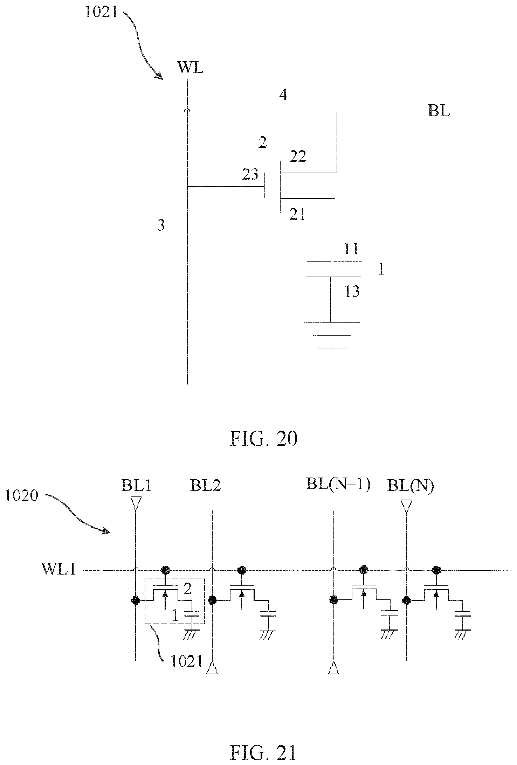

The three-dimensional memory 10 in this example further includes a word line (word line, WL) 3 and a bit line (bit line, BL) 4 shown in FIG. 20. The word line 3 is electrically connected to the gate 23 of the gating transistor 2, and the bit line 4 is electrically connected to the second electrode 22 of the gating transistor 2. The word line 3 is configured to input a gating signal to the gate 23 of the gating transistor 2, and the bit line 4 is configured to read stored data in the capacitor 1 or write stored data into the capacitor 1 when the gating transistor 22 is conducted.

Based on this, to enable one gating transistor 2 to correspond to one capacitor 1, data can be independently read and written into each capacitor 1. There are also N gating transistors 2 in the storage structure 1020 in this example, and first electrodes 21 of the N gating transistors 2 are electrically connected to first electrodes 11 of the N capacitors 1 in a one-to-one correspondence, to form N storage units 1021 shown in FIG. 21.

Correspondingly, the storage structure 1020 in this example has one word line 3 and N bit lines 4. The word line 3 is separately electrically connected to gates 23 of the N gating transistors 2, and the N bit lines 4 are electrically connected to second electrodes 22 of the N gating transistors 2 in a one-to-one correspondence. Correspondingly, the word line 3 and the bit line 4 are disposed at locations close to the gating transistor 2, to shorten lengths of the word line 3 and the bit line 4.

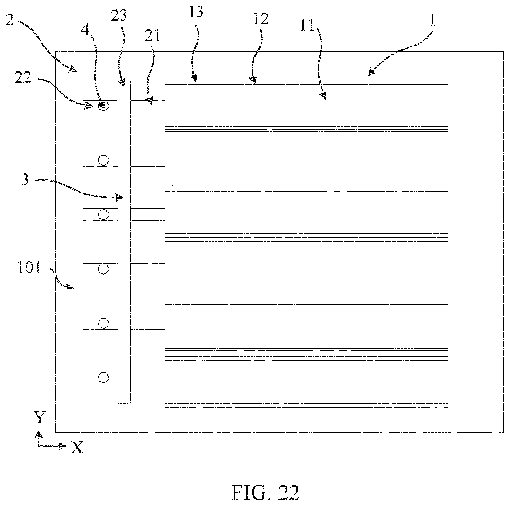

The bit line 4 is made of tungsten, and the bit line 4 can alternatively be made by using a process such as etching, deposition, or growth. FIG. 22 is a cross-sectional view of B-B in FIG. 9. Based on the foregoing description, in this example, the word line 3 is disposed on a side that is of the active layer of the gating transistor 2 and that is far away from the substrate 101, and a part that is of the word line 3 and that is lapped over the active layer serves as the gate 23 of the gating transistor 2, as shown in FIG. 22, so that the word line 3 and the gate 23 of the N gating transistors 2 are manufactured at the same time by using one patterning process. This simplifies process steps. In addition, the word line 3 and the gate 23 of the gating transistor 2 are made of the same material. Certainly, the word line 3 may alternatively be separately made. This is not limited in this example.

It may be understood that, for a solution in which the gate 23 of the gating transistor 2 is on the same layer and of the same material as the first electrode 21 of the capacitor 1, if the part that is of the word line 3 and that is lapped over the active layer serves as the gate 23 of the gating transistor 2, the gate 23 of the gating transistor 2, the first electrode 21 of the capacitor 1, and the word line 3 can be manufactured at the same time by using one patterning process.

### Example 2

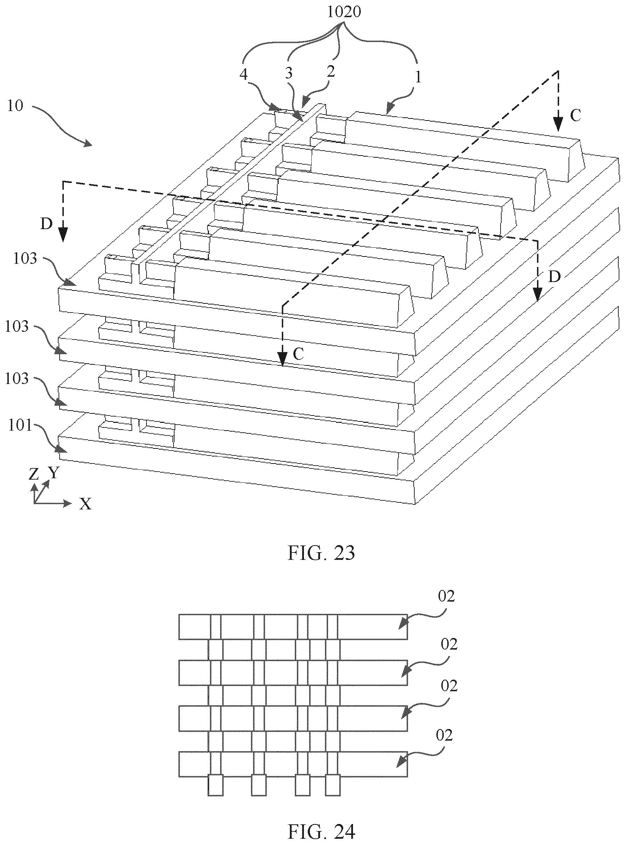

In this example, there is a three-dimensional memory 10 in which one storage array layer 102 shown in FIG. 9 is stacked with M layers in a Z-axis direction. M≥2, and M is an integer. The three-dimensional memory 10 shown in FIG. 23 is stacked with four (that is, M=4) storage array layers 102.

In the three-dimensional memory using the cylindrical capacitor 01 shown in FIG. 1, only a single-layer capacitor may be disposed in the three-dimensional memory. However, the capacitor 1 in the three-dimensional memory 10 in this example has a plurality of layers (for example, more than 100 layers), and can store more data in limited layout space, so that capacity of the three-dimensional memory 10 is large. In addition, a manufacturing process of the capacitor 1 having a thin-film layer structure is less difficult, and a manufacturing process of the plurality of storage array layers 102 is also less difficult. Therefore, the plurality of capacitors 1 in the manufactured three-dimensional memory 10 have good consistency and low defect states. Therefore, a defect rate of the electronic component in the three-dimensional memory 10 is also low, and reliability of the electronic component is high.

In addition, compared with the related technology shown in FIG. 24, the technology is a high bandwidth memory (high bandwidth memory, HBM) obtained by directly stacking and bonding a plurality of thinned storage chips (dies dies) 02. However, the three-dimensional memory 10 in this example can implement manufacturing of a structure having a plurality of storage array layers in a same die die. This implements three-dimensional stacking of storage structures in the die die, and improves capacity of the three-dimensional memory 10.

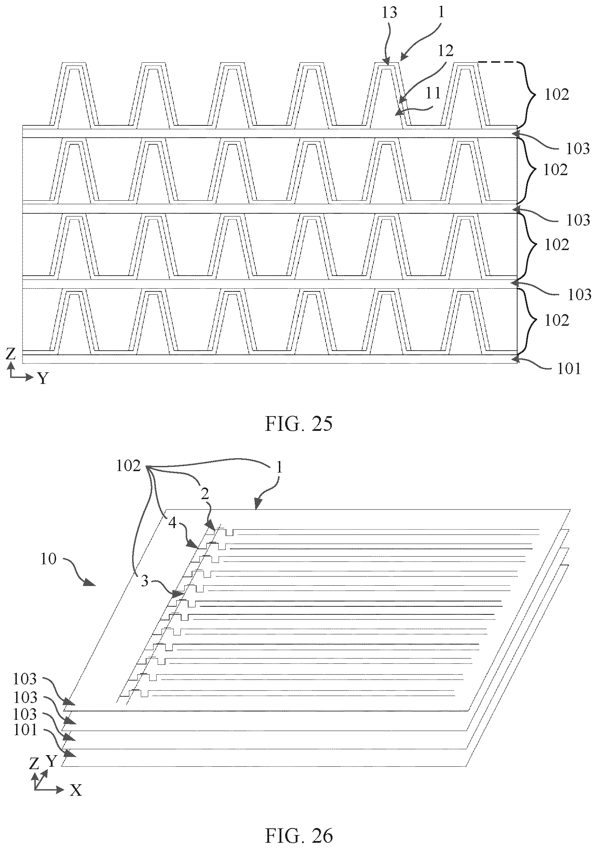

FIG. 25 is a schematic diagram of a cross section of C-C in FIG. 23. For a solution in which M storage array layers 102 are used, two adjacent storage array layers 102 are electrically isolated, for example, a first electrode 11 in an upper-layer capacitor is electrically isolated from a second electrode 13 in a lower-layer capacitor. Therefore, the three-dimensional memory 10 in this example further includes a second dielectric layer 103 shown in FIG. 25, and the second dielectric layer 103 is located between two adjacent storage array layers 102. The second dielectric layer 103 can implement electrical isolation between the two adjacent storage array layers 102. It should be noted that the second dielectric layer 103 may be made of a dielectric material having an inter-metal-dielectric (inter-metal-dielectric, IMD) layer, such as silicon dioxide (SiO2).

When the three-dimensional memory 10 is manufactured, a storage array layer 102 may be formed on the substrate 101 through process steps such as upward growth, epitaxy, etching, and deposition, and then a second dielectric layer 103 is formed on the storage array layer 102, and then another storage array layer 102 is formed on the second dielectric layer 103. This is repeated, to form more than 100 storage array layers 102 on each substrate 101. Because the plurality of storage array layers 102 may be formed by using a same photomask, process costs of the three-dimensional memory 10 can be reduced.

A solution in which both the word line 3 and the bit line 4 are located at the storage array layer 102 shown in FIG. 26 may be used for disposing locations of the word line 3 and the bit line 4 in the three-dimensional memory 10 in this example. A word line 3 at each storage array layer 102 is electrically connected to a gating transistor 2 at the layer. A bit line 4 at each storage array layer 102 is electrically connected to a gating transistor 2 at the layer.

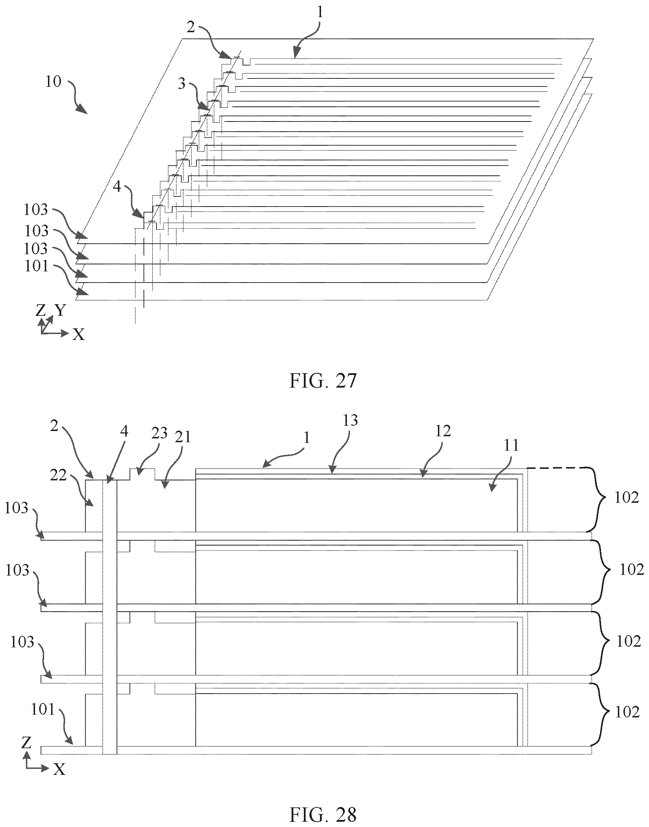

Alternatively, any storage array layer 102 in the three-dimensional memory 10 in this example includes a word line 3 electrically connected to gates 23 of N gating transistors 2 at the layer, and uses a bit line 4 structure shown in FIG. 27. There are N bit lines 4 in the three-dimensional memory 10, and the N bit lines 4 separately pass through the M storage array layers 102, and are electrically connected to second electrodes 22 of M gating transistors 2 located at a same location in the M storage array layers 102. Vertical projections of the M gating transistors 2 at the same location on the substrate 101 overlap, and the bit line 4 is a through-hole structure that passes through the M (M=4 in FIG. 28) storage array layer 102 to connect second electrodes 13 of capacitors 1 at different layers, as shown in FIG. 28. Because spacing between gating transistors 2 at different layers is small, a length of the required bit line 4 can be shortened.

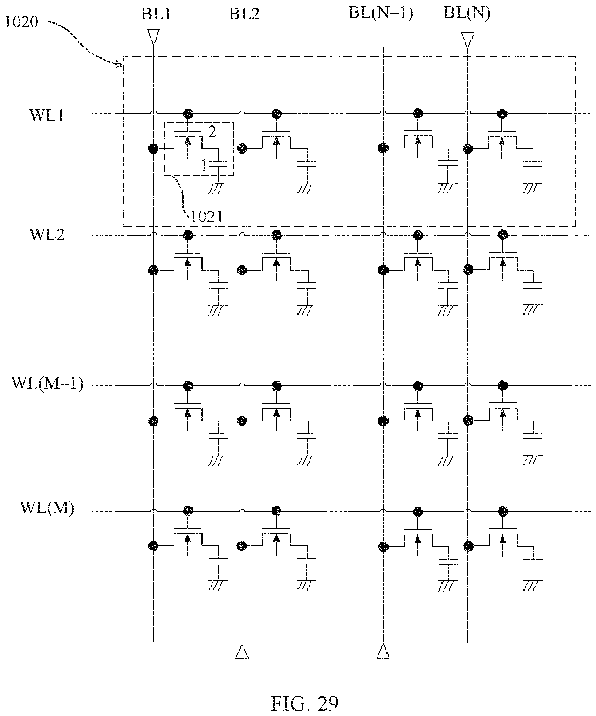

In the three-dimensional memory 10 shown in FIG. 29, there are M word lines 3 and N bit lines 4. Each storage array layer 102 includes N gating transistors 2 and N capacitors 1. First electrodes 21 of the N gating transistors 2 are electrically connected to first electrodes 11 of the N capacitors 1 in a one-to-one correspondence, to form N M×N storage units 1021 shown in FIG. 29.

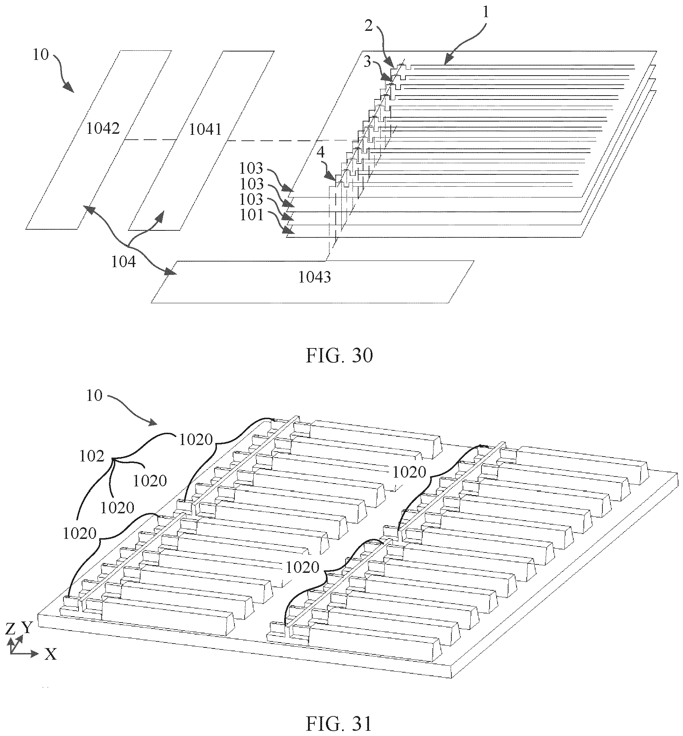

The three-dimensional memory 10 in this example further includes a peripheral circuit 104 shown in FIG. 30. The peripheral circuit 104 includes a read/write gating circuit 1041 (for example, a word line gating circuit (sub-word-line, SWL)), an address decoder (for example, a row decoder and a column decoder) 1042, a sense-amplitude (sense-amplitude, S/A) circuit 1043, and the like. The address decoder 1042 is electrically connected to the read/write gating circuit 1041, the read/write gating circuit 1041 is electrically connected to the word line 3, and the sense-amplitude circuit 1043 is electrically connected to the bit line 4.

After receiving a read instruction, the address decoder 1042 performs, based on address information included in the read instruction, conduction on the word line 3 corresponding to the address by using the read/write gating circuit 1041. Then, the bit line 4 reads data included in a capacitor 1 corresponding to the word line 3 that is conducted, and amplifies a data signal by using the sense-amplitude circuit 1043. After receiving a write instruction, the address decoder 1042 performs, based on address information included in the write instruction, conduction on the word line 3 corresponding to the address by using the read/write gating circuit 1041, and then writes data into a corresponding capacitor 1 by using the bit line 4.

It should be noted that the peripheral circuit 104 may be formed on the substrate 101, and may be located at an edge location of the substrate 101. The peripheral circuit 104 may be disposed at the same layer as the storage array layer 102 at the bottom layer. A manufacturing process of the peripheral circuit 104 may also be implemented through a plurality of processes, including but not limited to: photolithography, dry/wet etching, thin film deposition, thermal growth, implantation, chemical mechanical polishing, and any other suitable process. The word line 3 and the bit line 4 may be electrically connected to the peripheral circuit 104 on the substrate 101 by using a through-hole interconnection structure.

### Example 3

In this example, a three-dimensional memory 10 shown in FIG. 31 is used. The three-dimensional memory 10 is similar to the three-dimensional memory structure in Example 1, and a difference lies in that the storage array layer 102 includes S storage structures 1020, and the S storage structures 1020 are arranged in arrays. S≥2, and S is an integer.

Because a structure included in this example is the same as that in Example 1, same technical effect as that in Example 1 can be obtained. In addition, in this example, each storage array layer 102 includes the S storage structures 1020 arranged in arrays, that is, a larger quantity of capacitors 1 included in each storage array layer 102 indicates that a requirement of improving storage capacity of a terminal product with a large size that is parallel to the XY plane can be met.

It should be noted that a quantity of storage structures 1020 on the storage array layer 102 in this example is not limited herein. The storage array layer 102 in the three-dimensional memory 10 shown in FIG. 31 includes four (S=4) storage structures 1020, and the four storage structures 1020 are arranged in a rectangular array. Certainly, the S storage structures 1020 on the storage array layer 102 may also be arranged in a circular array.

### Example 4

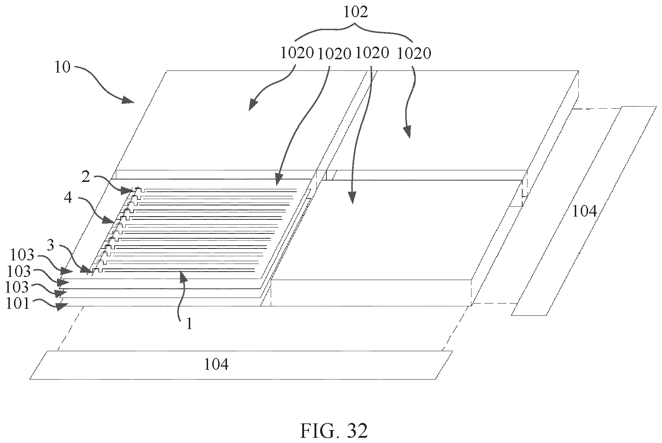

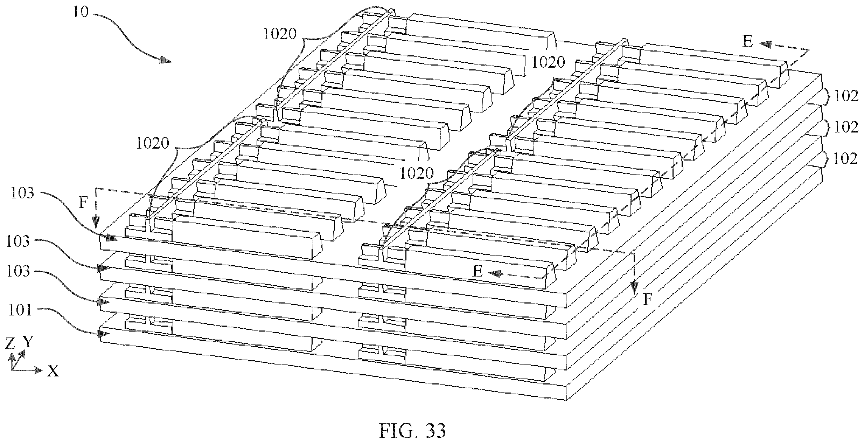

In this example, there is a three-dimensional memory 10 in which one storage array layer 102 shown in FIG. 31 is stacked with M layers in the Z-axis direction. In FIG. 32 and FIG. 33, an example in which four (M=4) storage array layers 102 are stacked in the three-dimensional memory 10 is used.

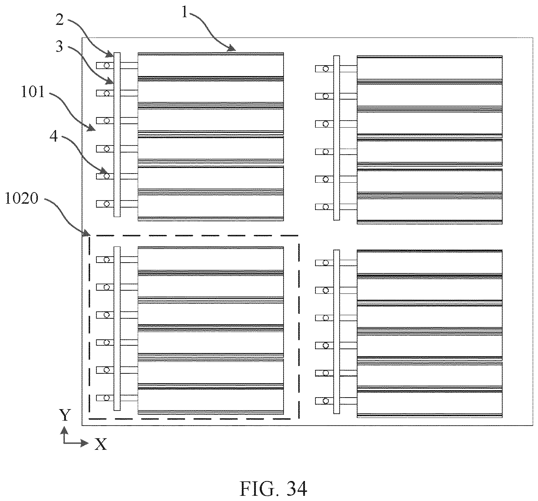

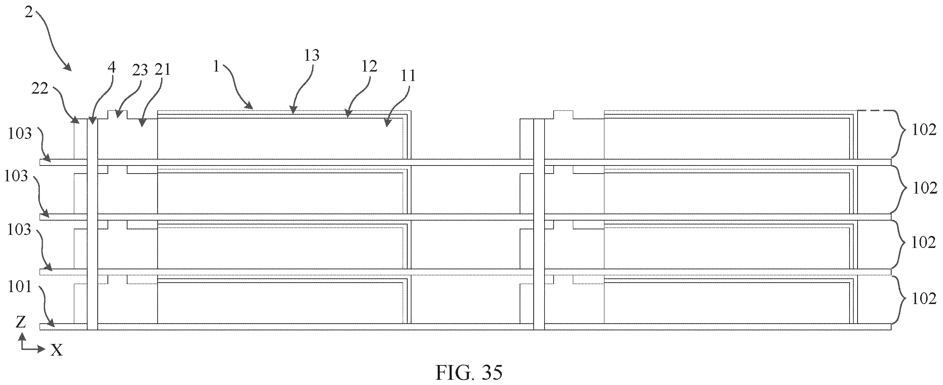

FIG. 34 is a schematic diagram of a cross section of E-E in FIG. 33, and FIG. 35 is a schematic diagram of a cross section of F-F in FIG. 33. With reference to FIG. 32, FIG. 33, and FIG. 34, it can be learned that, because a structure included in this example is the same as that in Example 3, same technical effect as that in Example 3 can be obtained. In addition, a capacitor 1 in the three-dimensional memory 10 in this example has a plurality of layers, and can store more data. In this way, capacity of the three-dimensional memory 10 is further improved.

### Example 5

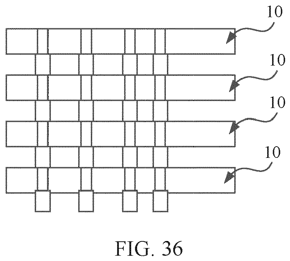

In this example, an electronic device in which a chip stacked structure shown in FIG. 36 is disposed, and the chip stacked structure may be located on a mainboard in the electronic device. In the chip stacked structure, a plurality of three-dimensional memories 10 (dies dies) shown in FIG. 32 are stacked, and the plurality of three-dimensional memories 10 may be electrically connected in a through-hole bonding manner, to further improve storage capacity of the electronic device and implement high-bandwidth storage of the electronic device. FIG. 36 is an example in which there are four dies in the chip stacked structure. Certainly, the chip stacked structure in this example may alternatively be included in a chip package structure.

In the descriptions of this specification, the described specific features, structures, materials, or characteristics may be combined in a proper manner in any one or more of embodiments or examples.

Finally, it should be noted that the foregoing embodiments are merely intended for describing the technical solutions of this application, but not for limiting this application. Although this application is described in detail with reference to the foregoing embodiments, persons of ordinary skill in the art should understand that they may still make modifications to the technical solutions described in the foregoing embodiments or make equivalent replacements to some technical features thereof, without departing from the spirit and scope of the technical solutions of embodiments of this application.

## Claims

1. A three-dimensional memory, comprising:
a substrate; and
a storage array layer, wherein the storage array layer comprises at least one storage structure, the storage structure comprises N capacitors disposed side by side on the substrate, the capacitor comprises a first electrode, a first dielectric layer, and a second electrode that are sequentially stacked on the substrate in a direction away from the substrate, N≥2, and N is an integer.

2. The three-dimensional memory according to claim 1, wherein the first dielectric layer covers a surface that is of the first electrode and that is away from the substrate, and at least one side surface of the first electrode; and
the second electrode covers a surface that is of the first dielectric layer and that is away from the substrate, and at least one side surface of the first dielectric layer, wherein second electrodes of two adjacent capacitors are disposed at an interval.

3. The three-dimensional memory according to claim 2, wherein first dielectric layers of the N capacitors are of a connected integrated structure.

4. The three-dimensional memory according to claim 1, wherein the three-dimensional memory comprises M storage array layers that are stacked in a direction perpendicular to the substrate, M≥2, and M is an integer; and
the three-dimensional memory further comprises a second dielectric layer, and the second dielectric layer is located between two adjacent storage array layers.

5. The three-dimensional memory according to any one of claims 2 to 4, wherein the N capacitors are disposed side by side in a first direction, a first cross section of the first electrode is a trapezoid, and the first cross section is parallel to the first direction and perpendicular to the substrate.

6. The three-dimensional memory according to claim 5, wherein the storage structure further comprises:
N gating transistors, wherein a first electrode of one gating transistor is electrically connected to a first electrode of one capacitor;
a word line, electrically connected to gates of the N gating transistors; and
a bit line, electrically connected to second electrodes of the N gating transistors.

7. The three-dimensional memory according to claim 5, wherein the storage structure further comprises:
N gating transistors, wherein a first electrode of one gating transistor is electrically connected to a first electrode of one capacitor; and
a word line, electrically connected to gates of the N gating transistors, wherein
the three-dimensional memory further comprises the M storage array layers that are stacked in the direction perpendicular to the substrate, M≥2, and M is an integer; and the three-dimensional memory further comprises:
N bit lines, wherein the bit lines pass through the M storage array layers and are electrically connected to second electrodes of M gating transistors at a same location in the M storage array layers, and vertical projections of the M gating transistors at the same location on the substrate overlap.

8. The three-dimensional memory according to claim 6 or 7, wherein the word line is disposed on a side that is of an active layer of the gating transistor and that is away from the substrate, and a part that is of the word line and that is lapped over the active layer serves as the gate of the gating transistor.

9. The three-dimensional memory according to claim 6 or 7, wherein a second cross section of the first electrode is a rectangle, the second cross section is perpendicular to both the first direction and the substrate, and a length direction of the rectangle is perpendicular to the first direction and parallel to the substrate;
the side surface of the first electrode comprises a first side surface and a second side surface that are both parallel to a second direction, wherein the second direction is perpendicular to the first direction; and
the first dielectric layer and the second electrode sequentially cover the first side surface and the second side surface.

10. The three-dimensional memory according to claim 9, wherein the side surface of the first electrode further comprises a third side surface and a fourth side surface that are both parallel to the first direction, the third side surface is disposed close to the gating transistor and is electrically connected to the first electrode of the gating transistor, and the first dielectric layer and the second electrode further sequentially cover the fourth side surface.

11. The three-dimensional memory according to any one of claims 6 to 10, wherein the substrate is a silicon substrate; and
the first electrode, the second electrode, and the active layer of the gating transistor are integrated in the silicon substrate, and the first electrode that is of the capacitor and that is electrically connected to the first electrode of the gating transistor is on a same layer and of a same material as the gate of the gating transistor.

12. The three-dimensional memory according to any one of claims 1 to 7, wherein the storage array layer comprises a plurality of storage structures arranged in an array.

13. A chip package structure, comprising:
a package substrate; and
the three-dimensional memory according to any one of claims 1 to 12, wherein the three-dimensional memory is disposed on the package substrate.

14. The chip package structure according to claim 13, wherein the chip package structure further comprises:
a control chip, wherein the control chip is disposed on the package substrate and is located on a same plane as the three-dimensional memory, or the control chip and the three-dimensional memory are stacked on the package substrate.

15. An electronic device, comprising:
a mainboard; and
the chip package structure according to claim 13 or 14, wherein the chip package structure is disposed on the mainboard and is electrically connected to the mainboard.
